# EUROPEAN PATENT APPLICATION

(11) **EP 3 199 499 A1**
(43) Date of publication of application: **02.08.2017**
(21) Application number: 15843968.7
(22) Date of filing: 18.08.2015
(51) Int. Cl.: C03B 33/04, B28D 5/00

(54) **METHOD FOR CUTTING BRITTLE SUBSTRATE**

(30) Priority: 25.09.2014 JP 2014194717
(71) Applicant: Mitsuboshi Diamond Industrial Co., Ltd., Settsu Osaka 566-0034 (JP)
(72) Inventor: SOYAMA, Hiroshi, Settsu city Osaka 566-0034 (JP)
(74) Representative: TBK
(86) International application number: PCT/JP2015/073100
(87) International publication number: WO 2016/047317

(57) **Abstract**

A cutter edge is pressed against a surface (SF) of a brittle substrate (4). The pressed cutter edge is slid on the surface (SF) of the brittle substrate (4) to generate plastic deformation on the surface (SF) of the brittle substrate (4), thereby forming a trench line (TL) having a groove shape. The step of forming the trench line (TL) is performed to obtain a crack-free state, in which the brittle substrate (4) seamlessly continues in a direction intersecting the trench line (TL) directly below the trench line (TL). The trench line (TL) includes a curved portion. A crack line (CL) is formed by extending a crack in the brittle substrate (4) in a thickness direction along the trench line (TL). The crack line (CL) breaks seamless continuity of the brittle substrate (4) in the direction intersecting the trench line (TL) directly below the trench line (TL).

## Description

### Technical Field

The present invention relates to a method for dividing a brittle substrate.

### Background Art

According to Patent Document 1, while a cutter is brought into pressure contact with a front surface of a brittle substrate, at least one of the brittle-material substrate and the cutter is moved to draw a closed curve to form a scribe line formed of a crack. Thereafter, stress is applied to the brittle-material substrate to cause the crack to grow to a back surface of the brittle-material substrate, and then the brittle-material substrate is divided.

### Prior Art Document

### Patent Document

Patent Document 1: Japanese Patent Application Laid-Open No. 2010-173905

### Summary of Invention

### Problems to be Solved by the Invention

It is difficult to uniformly form a scribe line with a curved portion as compared with a scribe line formed of only a straight line. A curved portion with a curvature radius of 5 mm or less particularly increases the difficulty. As a result, with a method using a scribe line with a curved portion, described in Patent Document 1, it is difficult to uniformly divide a brittle substrate along a shape including the curved portion.

The present invention has been made to solve the problem described above, and an object thereof is to provide a method for dividing a brittle substrate, the method capable of uniformly dividing a brittle substrate along a shape including a curved portion. Means for Solving the Problem

A method for dividing a brittle substrate of the present invention includes the following steps.

A brittle substrate including a surface and having a thickness direction perpendicular to the surface is prepared. A cutter edge is pressed against the surface of the brittle substrate.

A trench line having a groove shape is formed by causing the pressed cutter edge to slide on the surface of the brittle substrate to generate plastic deformation on the surface of the brittle substrate. The forming a trench line is performed to obtain a crack-free state, in which the brittle substrate seamlessly continues in a direction intersecting the trench line directly below the trench line. The trench line includes a curved portion.

A crack line is formed by extending a crack of the brittle substrate in the thickness direction along the trench line. The crack line breaks seamless continuity of the brittle substrate in the direction intersecting the trench line directly below the trench line.

### Effects of the Invention

According to the present invention, a shape into which the brittle substrate is divided is defined by a shape of the trench line. Unlike the conventional scribe line, the trench line can be uniformly formed even if the trench line includes a curved portion. This enables a brittle substrate to be uniformly divided along a shape including a curved portion.

### Brief Description of Drawings

Fig. 1 shows top views (A) and (B), respectively, schematically illustrating first and second steps of a method for dividing a brittle substrate in a first embodiment of the present invention.
Fig. 2 is a flowchart schematically illustrating a procedure of the method for dividing a brittle substrate in the first embodiment of the present invention.
Fig. 3 shows a side view (A) schematically illustrating a configuration of a tool used in the method for dividing a brittle substrate in the first embodiment of the present invention, and a plan view (B) schematically illustrating a configuration of a cutter edge provided in the tool, as viewed from an arrow IIIB in Fig. 3(A).
Fig. 4 shows a view (A) schematically illustrating a partial end face along line IVA-IVA in each of Figs. 1(A), 5(A), 6(A), and 7(A), and a view (B) schematically illustrating a partial end face along line IVB-IVB in each of Figs. 1(B), 5(B), 6(B), and 7(B).
Fig. 5 shows top views (A) and (B), respectively, schematically illustrating first and second steps of a method for dividing a brittle substrate in a second embodiment of the present invention.
Fig. 6 shows top views (A) and (B), respectively, schematically illustrating first and second steps of a method for dividing a brittle substrate in a third embodiment of the present invention.
Fig. 7 shows top views (A) and (B), respectively, schematically illustrating first and second steps of a method for dividing a brittle substrate in a fourth embodiment of the present invention.
Fig. 8 shows a side view (A) schematically illustrating a configuration of a tool used in the method for dividing a brittle substrate in a fifth embodiment of the present invention, and a plan view (B) schematically illustrating a configuration of a cutter edge provided in the tool, as viewed from an arrow VIIIB in Fig. 8(A).

### Description of Embodiments

Embodiments of the present invention will be described below with reference to the drawings. The same or corresponding portions are denoted by the same references in the drawings, and description thereof will not be repeated.

### First Embodiment

A method for dividing a brittle substrate of the present embodiment will be described below.

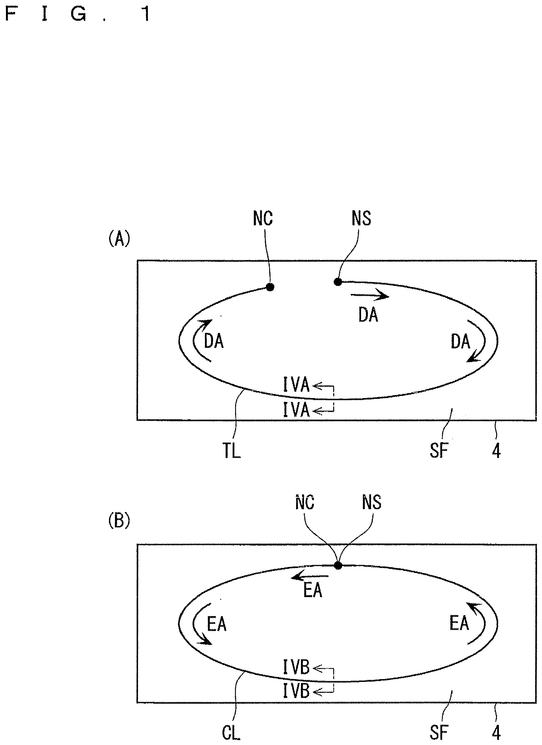

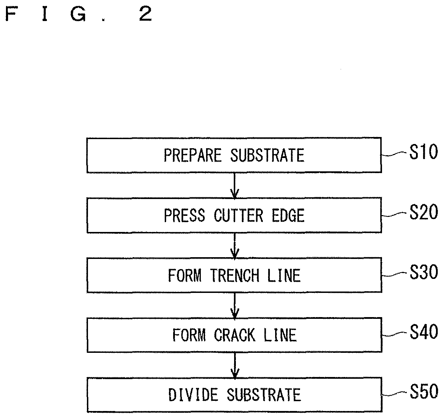

With reference to Fig. 1(A), a glass substrate 4 (brittle substrate) is prepared (Fig. 2: step S10). The glass substrate 4 has a surface SF.

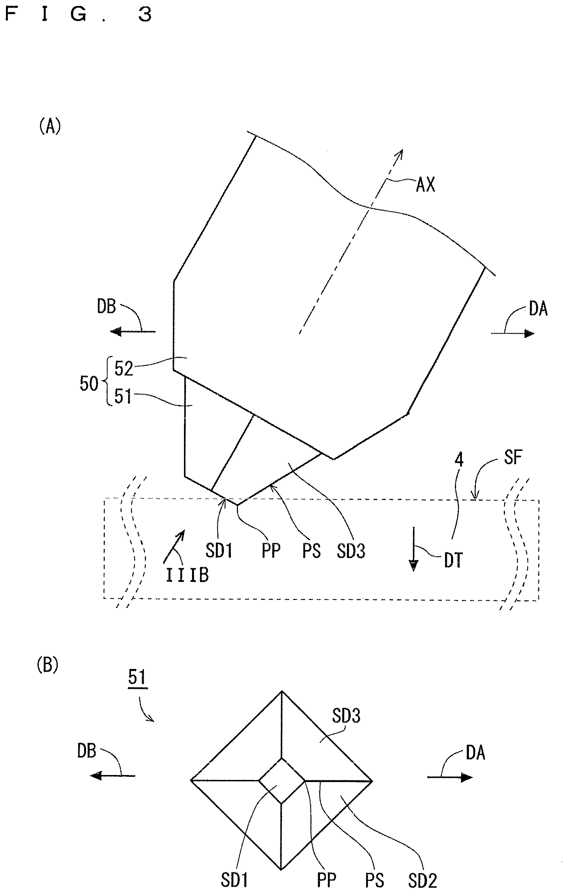

With reference to Figs. 3(A) and 3(B), a cutting tool 50 including a cutter edge 51 and a shank 52 is prepared. The cutter edge 51 is fixed to and held by the shank 52 serving as a holder.

The cutter edge 51 is provided with a top surface SD1 (first surface) and a plurality of surfaces surrounding the top surface SD1. The plurality of surfaces includes a side surface SD2 (second surface) and a side surface SD3 (third surface). The top surface SD1, and the side surfaces SD2 and SD3 (the first to third surfaces) are oriented in different directions and are adjacent to each other. The cutter edge 51 has a vertex at which the top surface SD1 and the side surfaces SD2 and SD3 meet, and the vertex forms a protruding portion PP of the cutter edge 51. The side surfaces SD2 and SD3 form a ridge forming a side portion PS of the cutter edge 51. The side portion PS extends in a line from the protruding portion PP. The side portion PS is a ridge as described above, and thus has a convex shape extending in a line.

It is preferable that the cutter edge 51 is a diamond point. That is, it is preferable that the cutter edge 51 is made of diamond in terms of hardness and reduced surface roughness. More preferably, the cutter edge 51 is made of single-crystal diamond. Still more preferably, in crystallography, the top surface SD1 is a {001} plane, and each of the side surfaces SD2 and SD3 is a {111} plane. In this case, the side surfaces SD2 and SD3 are crystal planes equivalent to each other in crystallography, although they have different directions.

Diamond other than single-crystal diamond may be used, and for example, polycrystalline diamond synthesized by chemical vapor deposition (CVD) may be used. Alternatively, polycrystalline diamond sintered from particulate graphite or non-graphitic carbon without containing a binder such as iron group elements, or sintered diamond obtained by binding diamond particles with a binder such as iron group elements, may be used.

The shank 52 extends along an axial direction AX. It is preferable that the cutter edge 51 is attached to the shank 52 such that the direction normal to the top surface SD1 extends substantially along the axial direction AX.

With reference to Fig. 1(A) again, the cutter edge 51 is then pressed against the surface SF of the glass substrate 4 at a starting point NS (one location) (Fig. 2: step S20). Specifically, the protruding portion PP and the side portion PS of the cutter edge 51 are pressed in a thickness direction DT of the glass substrate 4.

Subsequently, the pressed cutter edge 51 is slid in a direction DA from the starting point NS on the surface SF of the glass substrate 4. The direction DA is obtained by projecting, on the surface SF, a direction extending from the protruding portion PP along the side portion PS, and substantially corresponds to a direction in which the axial direction AX is projected on the surface SF. In this case, the cutter edge 51 is dragged on the surface SF by the shank 52. A position NC of the sliding cutter edge 51 defines a path including a curved portion, and ultimately approaches the starting point NS again.

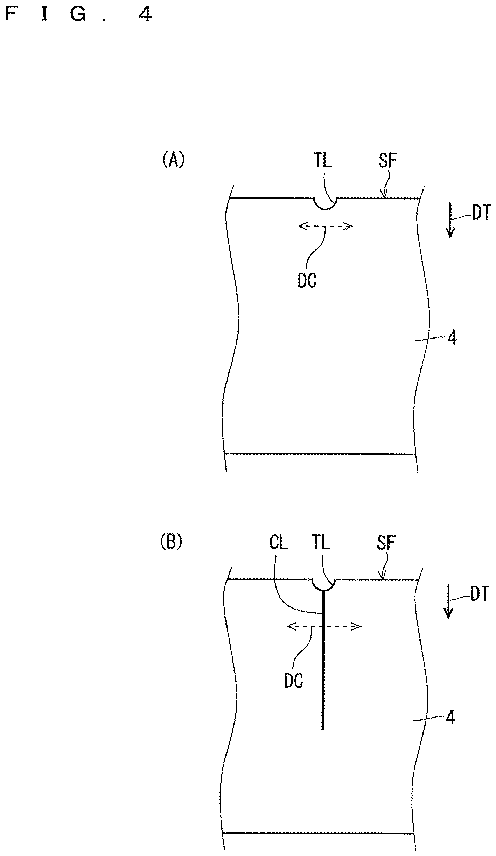

The above sliding causes plastic deformation on the surface SF of the glass substrate 4, thereby forming a trench line TL having a groove shape (Fig. 4(A)) (Fig. 2: step S30). The trench line TL includes a curved portion corresponding to the path of the position NC of the cutter edge 51. The curved portion may include a curvature radius of 5 mm or less.

A step of forming the trench line TL is performed to obtain a crack-free state, in which the glass substrate 4 seamlessly continues in a direction DC intersecting the trench line TL directly below the trench line TL. In the crack-free state, although the trench line TL is formed through the plastic deformation, no crack is formed along the trench line TL. To obtain the crack-free state, a load applied to the cutter edge 51 is set to be small so as to cause no crack and large so as to cause the plastic deformation.

The cutter edge 51 is further slid to return the position NC of the cutter edge 51 to the starting point NS. This forms the trench line TL forming a closed curve including the starting point NS. The closed curve may include a straight portion in addition to the curved portion.

With reference to Fig. 1(B), the position NC of the cutter edge 51 is returned to the starting point NS to start forming a crack line CL (Fig. 4(B)) in a direction EA along the trench line TL (Fig. 2: step S40). The crack line CL is formed by extending a crack of the glass substrate 4 in the thickness direction DT along the trench line TL. The crack line CL is a crack extending from a dent of the trench line TL in the thickness direction DT, and extends in a line on the surface SF. The crack line CL breaks seamless continuity of the glass substrate 4 in the direction DC (Fig. 4(B)) intersecting the trench line TL directly below the trench line TL. In other words, the "seamless continuity" herein refers to the continuity that is not interrupted by a crack. In the state in which the seamless continuity is broken as described above, portions of the glass substrate 4 may be in contact with each other with the crack of the crack line CL therebetween.

The direction EA in which the crack extends along the trench line TL is opposite to the direction DA (Fig. 1(A)) in which the cutter edge 51 slides in the step of forming the trench line TL. That is, there is directional dependence that affects easiness of extension of the crack line CL. It is assumed that the directional dependence is caused by distribution of internal stress generated in the glass substrate 4 when the trench line TL is formed.

It should be noted that the scribe line described above includes a trench line TL and a crack line CL (Fig. 3(B)) that are simultaneously formed by sliding or rolling of the cutter edge 51, and the timing of forming the crack line CL is different from that of the present embodiment.

Subsequently, the glass substrate 4 is divided along the crack line CL (Fig. 2: step S50). That is, so-called a breaking step is performed. The breaking step can be performed by applying external force to the glass substrate 4 to bend the glass substrate 4.

If the crack line CL fully penetrates in the thickness direction DT during formation thereof, the glass substrate 4 can be divided at the same time when the crack line CL is formed. In this case, the breaking step can be omitted.

According to the present embodiment, a shape into which the glass substrate 4 is divided is defined by a shape of the trench line TL. Unlike the conventional scribe line, the trench line TL can be uniformly formed even if the trench line TL includes a curved portion. Accordingly, the glass substrate 4 can be uniformly divided along the shape including the curved portion. In particular, when a curved portion has a curvature radius of 5 mm or less, a significant effect is obtained by application of the present embodiment.

### Second Embodiment

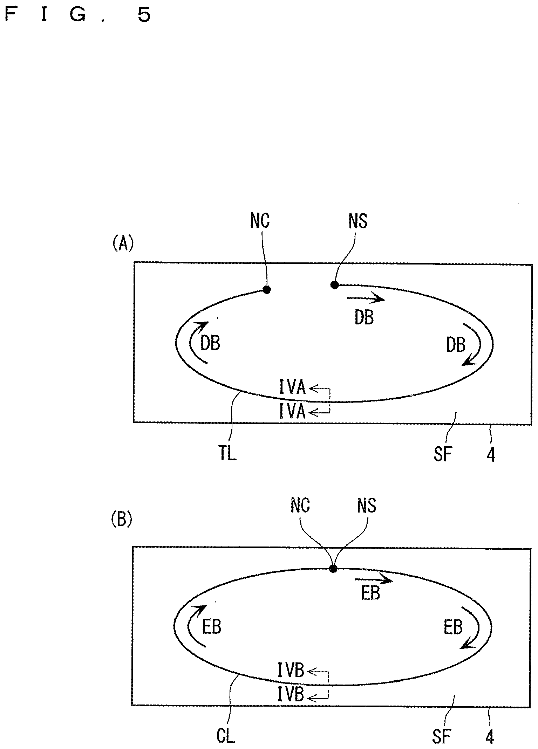

With reference to Fig. 5(A), in the present embodiment, a cutter edge 51 pressed against a surface SF of a glass substrate 4 at a starting point NS (one location) is slid in a direction DB instead of the direction DA. The direction DB is obtained by projecting, on the surface SF, a direction extending to a protruding portion PP along a side portion PS (refer to Figs. 3(A) and 3(B)), and substantially corresponds to a direction opposite to the direction in which an axial direction AX is projected on the surface SF. In this case, the cutter edge 51 is pressed forward on the surface SF by a shank 52. The above sliding forms a trench line TL (Fig. 4(A)).

With reference to Fig. 5(B), a position NC of the cutter edge 51 is returned to the starting point NS to start forming a crack line CL (Fig. 4(B)) in a direction EB along the trench line TL (Fig. 2: step S40). The direction EB in which a crack extends along the trench line TL is identical to the direction DA (Fig. 1(A)) in which the cutter edge 51 slides in the step of forming the trench line TL.

Since the configuration other than the above is substantially identical to the configuration of the first embodiment described above, the same or corresponding element is designated by the same reference numeral and description thereof is not repeated.

According to the present embodiment, substantially the same effect as that of the first embodiment can be achieved.

### Third Embodiment

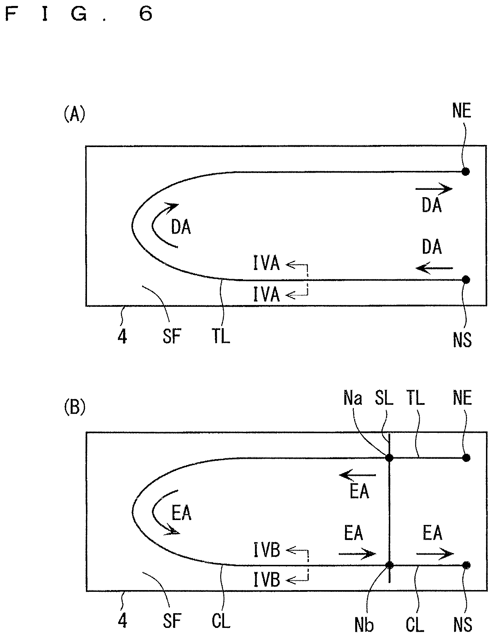

With reference to Fig. 6(A), in the present embodiment, a cutter edge 51 (Fig. 3(A)and (B)) pressed against a surface SF of a glass substrate 4 at a starting point NS is slid in a direction DA to an ending point NE away from the starting point NS. This sliding forms a trench line TL including a curved portion (Fig. 4(A)). The cutter edge 51 that has reached the ending point NE is moved away from the surface SF of the glass substrate 4.

With reference to Fig. 6(B), a step of forming a crack line CL is started by applying stress to the glass substrate 4 on the trench line TL. In the present embodiment, a scribe line SL intersecting the trench line TL is formed on the surface SF of the glass substrate 4. The scribe line SL intersects the trench line TL at each of intersections Na and Nb. Accordingly, forming of the crack line CL is started from each of the intersections Na and Nb in a direction EA opposite to the direction DA. If sufficient stress to start forming the crack line CL is not obtained during formation of the scribe line SL, formation of the crack line CL may be started by dividing the glass substrate 4 along the scribe line SL to apply larger stress. In addition, both of the intersections Na and Nb are not necessarily provided, and thus only an intersection suitable for a starting point of forming the crack line CL in the direction EA may be provided. Specifically, providing at least the intersection Na enables the crack line CL to be formed along a main section including a curved portion of the trench line TL. A method for applying stress is not limited to the method described above.

Since the configuration other than the above is substantially identical to the configuration of the first embodiment described above, the same or corresponding element is designated by the same reference numeral and description thereof is not repeated.

According to the present embodiment, substantially the same effect as that of the first embodiment can be achieved. In addition, according to the present embodiment, the glass substrate 4 can be divided along a shape different from a closed curve.

### Fourth Embodiment

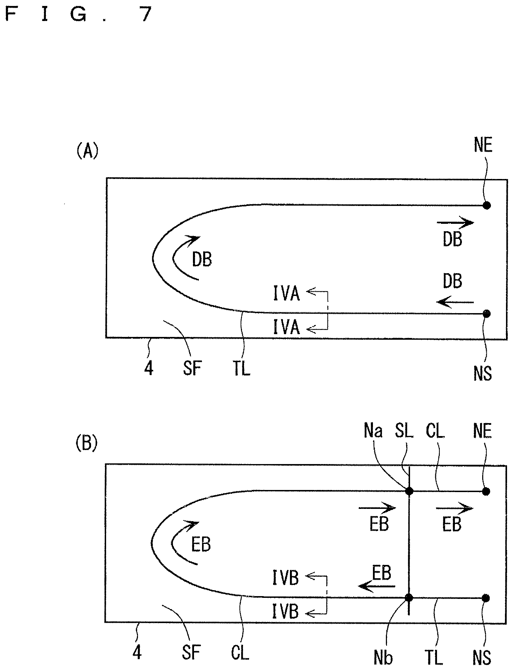

With reference to Fig. 7(A), in the present embodiment, a cutter edge 51 (Figs. 3(A) and 3(B)) pressed against a surface SF of a glass substrate 4 at a starting point NS is slid in a direction DB to an ending point NE. This sliding forms a trench line TL including a curved portion (Fig. 4(A)). The cutter edge 51 that has reached the ending point NE is moved away from the surface SF of the glass substrate 4.

With reference to Fig. 7(B), a step of forming a crack line CL is started by applying stress to the glass substrate 4 on the trench line TL. In the present embodiment, a scribe line SL intersecting the trench line TL is formed on the surface SF of the glass substrate 4. The scribe line SL intersects the trench line TL at each of intersections Na and Nb. Accordingly, forming of the crack line CL is started from each of the intersections Na and Nb in a direction EB identical to the direction DB. If sufficient stress to start forming the crack line CL is not obtained during formation of the scribe line SL, forming of the crack line CL may be started by dividing the glass substrate 4 along the scribe line SL to apply larger stress. In addition, both of the intersections Na and Nb are not necessarily provided, and thus only an intersection suitable for a starting point of forming the crack line CL in the direction EB may be provided. Specifically, providing at least the intersection Nb enables the crack line CL to be formed along a main section including a curved portion of the trench line TL. A method for applying stress is not limited to the method described above.

Since the configuration other than the above is substantially identical to the configuration of the second or third embodiment described above, the same or corresponding element is designated by the same reference numeral and description thereof is not repeated.

According to the present embodiment, substantially the same effect as that of the third embodiment can be achieved.

### Fifth Embodiment

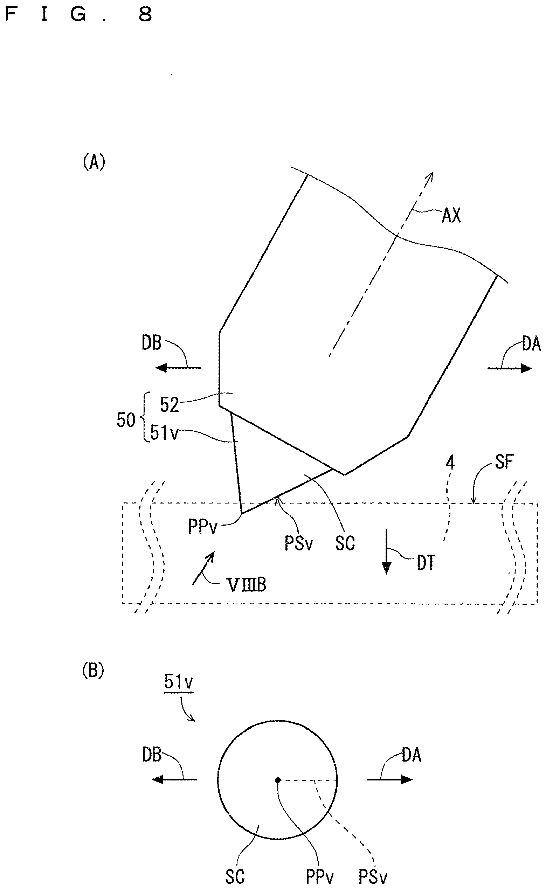

With reference to Figs. 8(A) and 8(B), a cutter edge 51v may be used instead of the cutter edge 51 (Figs. 3(A) and 3(B)) in each of the above embodiments. The cutter edge 51v has a conical shape with a vertex and a conical surface SC. A protruding portion PPv of the cutter edge 51v is formed by the vertex. A side portion PSv of the cutter edge is formed along a virtual line (the broken line in Fig. 8(B)) extending from the vertex on the conical surface SC. Accordingly, the side portion PSv has a convex shape extending in a line.

While a glass substrate is used as a brittle substrate in each of the above embodiments, the brittle substrate is not limited to the glass substrate, and thus any substrate made of brittle material may be used. Brittle material other than glass includes, for example, ceramic, silicon, compound semiconductor, sapphire, and quartz.

In the present invention, each of the embodiments may be freely combined, or modified or omitted as appropriate within the scope of the invention.

### Reference Signs List

- 4:: glass substrate (brittle substrate)
- 51, 51 v:: cutter edge
- CL:: crack line
- SF:: surface
- SL:: scribe line
- TL:: trench line

## Claims

1. A method for dividing a brittle substrate, the method comprising:
preparing a brittle substrate including a surface and having a thickness direction perpendicular to said surface;
pressing a cutter edge against said surface of said brittle substrate;
forming a trench line having a groove shape by causing said cutter edge pressed in said pressing to slide on said surface of said brittle substrate to generate plastic deformation on said surface of said brittle substrate, said forming a trench line being performed to obtain a crack-free state, in which said brittle substrate seamlessly continues in a direction intersecting said trench line directly below said trench line, said trench line including a curved portion, and
forming a crack line by extending a crack of said brittle substrate in said thickness direction along said trench line, said crack line breaking seamless continuity of said brittle substrate in the direction intersecting said trench line directly below said trench line.

2. The method for dividing a brittle substrate according to claim 1, wherein
said forming a trench line includes sliding said cutter edge at one location on said surface of said brittle substrate, and returning said cutter edge to said one location by further sliding said cutter edge, and
said forming a crack line is started by returning said cutter edge to said one location.

3. The method for dividing a brittle substrate according to claim 1, the method further comprising:
moving away said cutter edge from said surface of said brittle substrate after said forming a trench line and before said forming a crack line,
wherein said forming a crack line is started by applying stress to said brittle substrate on said trench line.

4. The method for dividing a brittle substrate according to any one of claims 1 to 3, wherein
a direction in which a crack extends along said trench line in said forming a crack line is opposite to a direction in which said cutter edge is slid in said forming a trench line.

5. The method for dividing a brittle substrate according to any one of claims 1 to 3, wherein
a direction in which a crack extends along said trench line in said forming a crack line is identical to a direction in which said cutter edge is slid in said forming a trench line.
